# EUROPEAN PATENT APPLICATION

(11) **EP 4 199 668 A1**
(43) Date of publication of application: **21.06.2023**
(21) Application number: 21859931.4
(22) Date of filing: 13.07.2021
(51) Int. Cl.: H05K 7/20

(54) **HEAT DISSIPATING ASSEMBLY AND AUTOMOBILE**

(30) Priority: 31.08.2020 CN 202010901492
(71) Applicant: Huawei Technologies Co., Ltd., Shenzhen, Guangdong 518129 (CN)
(72) Inventor: JIA, Hui, Shenzhen, Guangdong 518129 (CN); HU, Zhenming, Shenzhen, Guangdong 518129 (CN)
(74) Representative: Gill Jennings & Every LLP
(86) International application number: PCT/CN2021/105884
(87) International publication number: WO 2022/042091

(57) **Abstract**

Embodiments of this application provide a heat dissipation component, including: a first heat conduction component and a first fixed plate. The first fixed plate is fixedly connected to a PCB board, and a side of the PCB board is provided with a first heat generating device. The first fixed plate is located on a side, of the first heat generating device, facing away from the PCB board. The first fixed plate is provided with a first through hole, the first heat conduction component passes through the first through hole, and a side of the first heat conduction component adheres to the first heat generating device. The computing apparatus provided in this application may be applied to an autonomous vehicle, an intelligent vehicle, a connected vehicle, and a new energy vehicle. In this application, the first heat generating device adheres to the first heat conduction component, and the first heat conduction component may take away heat from the first heat generating device. In this application, a size of the heat dissipation component is reduced while heat dissipation performance is ensured.

## Description

This application claims priority to Chinese Patent Application No. 202010901492.7, filed with the China National Intellectual Property Administration on August 31, 2020 and entitled "HEAT DISSIPATION COMPONENT AND VEHICLE", which is incorporated herein by reference in its entirety.

### TECHNICAL FIELD

This application relates to the field of hardware structure technologies, and in particular, to a heat dissipation component and a vehicle.

### BACKGROUND

Automated driving has gradually become a new market, and one of key components is an artificial intelligence (artificial intelligence, Al) control chip and a PCB board of the Al control chip for automated driving. As a required computing power increases, a power of an advanced driver assistance system (advanced driver assistance system, ADAS) or a mobile data center (mobile data center, MDC) is increasingly high. Air cooling cannot resolve a heat dissipation problem, and therefore, a liquid cooling technology is required.

An existing heat dissipation component includes a cooling plate with a boss, thermal grease, a printed circuit board (printed circuit board, PCB), and a heat generating device (such as a chip). The heat generating device is on the PCB board, and heat conduction is implemented between a surface of the heat generating device and the cooling plate through the thermal grease. However, due to a large filling thickness of the thermal grease, a large temperature rise occurs.

### SUMMARY

According to a first aspect, this application provides a heat dissipation component, including: a first heat conduction component and a first fixed plate. The first fixed plate is fixedly connected to a PCB board, and a side of the PCB board is provided with a first heat generating device. The first fixed plate is located on a side, of the first heat generating device, facing away from the PCB board. The first fixed plate is provided with a first through hole, the first heat conduction component passes through the first through hole, and a side of the first heat conduction component adheres to the first heat generating device. The first fixed plate may be a plate-shaped metal plate made of a material such as aluminum or aluminum alloy, and the first fixed plate and the PCB board may be fixed at an angle parallel or approximately parallel. The PCB board may be a mainboard or a PCB board having another function, provided with one or more heat generating devices. The heat generating device may be a device such as an SOC chip, a local area network switch LAN SW, or a microcontroller unit (microcontroller unit, MCU). The first heat generating device is one of the one or more heat generating devices arranged on the PCB board. The PCB board has two faces, and heat generating devices may be arranged on both of the faces. Because the first fixed plate is located on the side, of the first heat generating device, facing away from the PCB board, the first heat generating device is provided on a face, of the PCB board, facing the first fixed plate. Optionally, a high-power heat generating device is arranged on one of the two faces of the PCB board, and a low-power heat generating device is arranged on the other face, and the first heat generating device may be arranged on the face, of the PCB board, on which the high-power heat generating device is arranged, and the first heat generating device may be a high-power heat generating chip. The first fixed plate is provided with the first through hole, the first heat conduction component passes through the first through hole, and the side of the first heat conduction component adheres to the first heat generating device. The side of the first heat conduction component may adhere to the first heat generating device through direct contact, or may adhere to the first heat generating device through indirect contact by smearing silicone grease.

In this embodiment of this application, the first heat generating device adheres to the first heat conduction component, and the first heat conduction component may take away heat from the first heat generating device. From a perspective of a size of a heat conduction component, because the first heat conduction component passes through the through hole of the first fixed part, the size of the first heat conduction component may be adapted to a size of the through hole. Compared with a liquid cooling plate in a conventional technology, a dimension and a weight of the first heat conduction component in this embodiment are smaller. In addition, in terms of thickness, because the first heat conduction component passes through the through hole of the first fixed part, a thickness of the heat dissipation component in this embodiment is less than that used when a fixed plate and a liquid cooling plate are separately arranged.

In a possible implementation, the side of the PCB board is further provided with a second heat generating device, and the heat dissipation component further includes a second heat conduction component and a flexible connector. The first heat conduction component and the second heat conduction component are connected through the flexible connector. The first fixed plate is further provided with a second through hole, the second heat conduction component passes through the second through hole, and a side of the second heat conduction component adheres to the second heat generating device.

The first heat conduction component and the second heat conduction component are connected through the flexible connector to form a whole, and the flexible pipeline enables the first heat conduction component and the second heat conduction component to move up or move down for a specific distance along a direction perpendicular to a plane of the first fixed plate. In some scenarios, the first heat generating device and the second heat generating device are not on the same plane, and in addition, because the first heat conduction component and the second heat conduction component can move up or move down for a specific distance along the direction perpendicular to the plane of the first fixed plate, the first heat conduction component and the second heat conduction component can closely adhere to a corresponding heat generating device well.

In a possible implementation, the first heat conduction component is a water block. The first heat conduction component may be alternatively another component with a heat conduction capability such as a liquid cooling plate.

In a possible implementation, the heat dissipation component further includes a heat conduction pipe. The heat conduction pipe is connected to the first heat conduction component, a groove is provided on a side, of the first fixed plate, facing the PCB board, and the heat conduction pipe adheres to an inner wall of the groove. It is determined whether a power of a device on which heat dissipation is required on the PCB board is too high so that the heat dissipation cannot be resolved through natural heat dissipation, and if the power of the device on which the heat dissipation is required on the PCB board is very high, the heat conduction pipe may adhere to the inner wall of the groove on the first fixed plate, so that heat generated by the device on which the heat dissipation is required on the PCB board is transferred to the fixed plate.

In a possible implementation, the heat conduction pipe is a metallic pipe. The heat conduction pipe may be alternatively a rigid pipe such as a plastic pipe with a better heat-conducting property.

In a possible implementation, a third heat generating device is further provided on a side of the PCB board, a boss is arranged on the side, of the first fixed plate, facing the PCB board, and a side, of the third heat generating device, facing the first fixed plate adheres to the boss.

In a possible implementation, the first heat conduction component is floatingly connected to the PCB board, so that a side of the first heat conduction component adheres to the first heat generating device. The heat conduction component may be installed to fit the first fixed plate, where the first heat conduction component may directly pass through the first through hole of the first fixed plate, and fasten and lock a spring screw and a board bracket to the first heat generating device (the board bracket may be but not limited to being arranged on a bottom housing), so that the first heat conduction component can be floatingly connected to the PCB board, and further, the first heat conduction component may adhere to the first heat generating device.

In a possible implementation, the dissipation component further includes a sealing cover. The sealing cover is fastened onto a side, of the first fixed plate, facing away from the PCB board, to seal the first through hole. In this embodiment of this application, to seal the through hole provided on the first fixed plate, the sealing cover can be fastened onto the side, of the first fixed plate, facing away from the PCB board, to seal the first through hole. Specifically, the sealing cover may be provided on the first fixed plate. The sealing cover may be locked in a local area near a heat conduction component (the first heat conduction component or the second heat conduction component); the sealing cover may be locked in a local area near heat conduction components (the first heat conduction component and the second heat conduction component); or the sealing cover may be locked on an outer edge of the entire first fixed plate, and all joints are fastened through sealing rings and screws to meet airtight requirements.

According to a second aspect, this application provides a method for installing a vehicle-mounted computing apparatus. The method includes:
fixedly connecting a side of the first fixed plate to a PCB board, where a side of the PCB board is provided with a first heat generating device, the first fixed plate is located on a side, of the first heat generating device, facing away from the PCB board, and the first fixed plate is provided with a first through hole;
enabling the first heat conduction component to pass through the first through hole, and enabling a side of the first heat conduction component to adhere to the first heat generating device; and
fastening a sealing cover onto a side, of the first fixed plate, facing away from the PCB board, to seal the first through hole.

According to a third aspect, this application provides a vehicle, including a vehicle body, and the heat dissipation component according to any one of the possible implementations of the first aspect provided in the vehicle body.

In this application, the designs in the foregoing aspects can be further combined to provide more designs.

Embodiments of this application provide the heat dissipation component, including: the first heat conduction component and the first fixed plate. The first fixed plate is fixedly connected to the PCB board, and the side of the PCB board is provided with the first heat generating device. The first fixed plate is located on the side, of the first heat generating device, facing away from the PCB board. The first fixed plate is provided with the first through hole, the first heat conduction component passes through the first through hole, and the side of the first heat conduction component adheres to the first heat generating device. In embodiments of this application, the first heat generating device adheres to the first heat conduction component, and the first heat conduction component may take away heat from the first heat generating device. From a perspective of a size of a heat conduction component, because the first heat conduction component passes through the through hole of the first fixed part, the size of the first heat conduction component may be adapted to a size of the through hole. Compared with a liquid cooling plate in a conventional technology, a dimension and a weight of the first heat conduction component in this embodiment are smaller. In addition, in terms of thickness, because the first heat conduction component passes through the through hole of the first fixed part, a thickness of the heat dissipation component in this embodiment is less than that used when a fixed plate and a liquid cooling plate are separately arranged.

### BRIEF DESCRIPTION OF DRAWINGS

FIG. 1a is a schematic diagram of a structure of a vehicle according to an embodiment of this application;
FIG. 1b is a schematic diagram of a structure of a heat dissipation component according to an embodiment of this application;
FIG. 2 is a schematic diagram of a structure of a heat dissipation component according to an embodiment of this application;
FIG. 3 is a schematic diagram of a structure of a heat dissipation component according to an embodiment of this application;
FIG. 4 is a schematic diagram of a structure of a heat dissipation component according to an embodiment of this application;
FIG. 5 is a schematic diagram of a structure of a heat dissipation component according to an embodiment of this application;
FIG. 6 is a schematic diagram of a structure of a heat dissipation component according to an embodiment of this application;
FIG. 7 is a schematic diagram of a structure of a heat dissipation component according to an embodiment of this application;
FIG. 8 is a schematic diagram of a structure of a heat dissipation component according to an embodiment of this application;
FIG. 9 is a schematic diagram of a structure of a heat dissipation component according to an embodiment of this application;
FIG. 10 is a schematic diagram of a structure of a heat dissipation component according to an embodiment of this application; and
FIG. 11 is a schematic diagram of a structure of a heat dissipation component according to an embodiment of this application.

### DESCRIPTION OF EMBODIMENTS

The following describes embodiments of the present invention with reference to the accompanying drawings in embodiments of the present invention. Terms used in implementations of the present invention are merely used to explain specific embodiments of the present invention, but are not intended to limit the present invention.

The following describes embodiments of this application with reference to the accompanying drawings. A person of ordinary skill in the art may know that: With the evolution of technologies and the emergence of new scenarios, the technical solutions provided in embodiments of this application are also applicable to similar technical problems.

In the specification, claims, and accompanying drawings of this application, the terms "first", "second", and so on are intended to distinguish between similar objects but do not necessarily indicate a specific order or sequence. It should be understood that the terms used in such a way are interchangeable in proper circumstances, and this is merely a discrimination manner for describing objects having a same attribute in embodiments of this application. In addition, the terms "include", "contain" and any other variants mean to cover the non-exclusive inclusion, so that a process, method, system, product, or device that includes a series of units is not necessarily limited to those units, but may include other units not expressly listed or inherent to such a process, method, product, or device.

First, an application scenario of a heat dissipation component provided in this application is described. The heat dissipation component provided in this application may be applied to a vehicle, for example, may be applied to a vehicle-mounted computing apparatus in the vehicle. The vehicle-mounted computing apparatus is applied to automated driving (automated driving) of an intelligent vehicle. The intelligent vehicle includes an electric vehicle or a gasoline-powered vehicle that supports unmanned driving (unmanned driving), driver assistance (driver assistance/ADAS), intelligent driving (intelligent driving), connected driving (connected driving), intelligent network driving (intelligent network driving), and car sharing (car sharing). The vehicle-mounted computing apparatus is configured to control and monitor a driving state of the intelligent vehicle, including but not limited to a vehicle-mounted mobile data center (mobile data center, MDC), a human machine interface (human machine interface, HMI) that implements a function of a human-machine interaction controller, an in-vehicle infotainment (in-vehicle infotainment, IVI) controller, a body control module (body control module, BCM), and a vehicle control unit (vehicle control unit, VCU). The vehicle-mounted computing apparatus may be specifically a chip having computing and processing capabilities, or may be a collection of a plurality of devices such as a processor and a memory integrated in a printed circuit board (printed circuit board, PCB), where the processor includes but is not limited to a central processing unit (central processing unit, CPU), a general-purpose processor, a digital signal processor (digital signal processor, DSP), an application-specific integrated circuit (application-specific integrated circuit, ASIC), a field-programmable gate array (field-programmable gate array, FPGA) or another programmable logic device, a discrete gate or a transistor logic device, a discrete hardware component, a graphics processing unit (graphics processing unit, GPU), an artificial intelligence (artificial intelligence, AI) chip, or the like. The general-purpose processor may be a microprocessor, any conventional processor, or the like. It can be learned from the foregoing description that the vehicle-mounted computing apparatus is provided with a chip having a relatively large computation amount. Therefore, when the vehicle-mounted computing apparatus is used, a relatively high requirement for heat dissipation is required. For this reason, this application provides a heat dissipation component to improve an effect of heat dissipation of the chip.

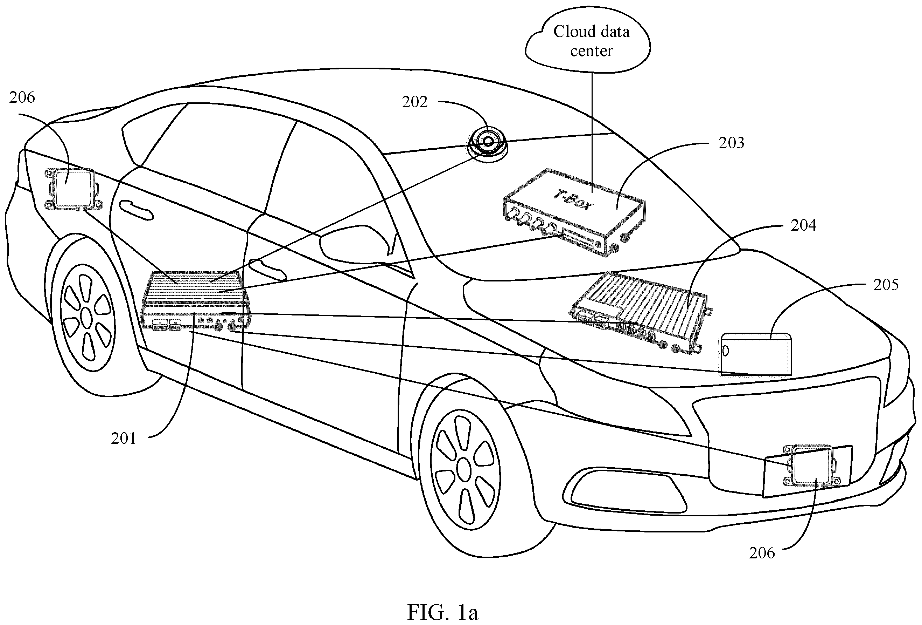

For example, as shown in FIG. 1a, a vehicle-mounted computing apparatus 201 may be installed in a suitable position such as a center console or close to a liquid cooling pump of the vehicle, detect an environment of the vehicle through various sensors (such as a millimeter-wave radar 206, a laser radar 205, and a camera 202) installed on a vehicle body, and then feed the environment back to a built-in chip of the vehicle-mounted computing apparatus 201 for real-time reasoning and computation, and finally, the vehicle-mounted computing apparatus 201 sends an operation command to a vehicle control unit (vehicle control unit, VCU) 204, and controls (for example, braking and decelerating) a motor vehicle through the VCU 204 to implement various levels of automated driving functions. The vehicle-mounted computing apparatus 201 may alternatively upload data to a backend cloud data center by using a T-BOX (telematics BOX) 203. Optionally, the vehicle-mounted computing apparatus 201 may perform transmission with the camera 202 through a multimedia serial link (multimedia serial link, MSL); perform transmission with the laser radar 205 through an in-vehicle Ethernet link; perform transmission with the VCU 204 through a controller area network (controller area network, CAN) bus; perform transmission with a millimeter-wave radar 206 through the CAN bus; and perform transmission with the T-BOX 203 through an in-vehicle Ethernet link.

The vehicle-mounted computing apparatus 201 in this application may include a heat dissipation component, configured to provide heat dissipation for a heat dissipation device in the vehicle-mounted computing apparatus 201.

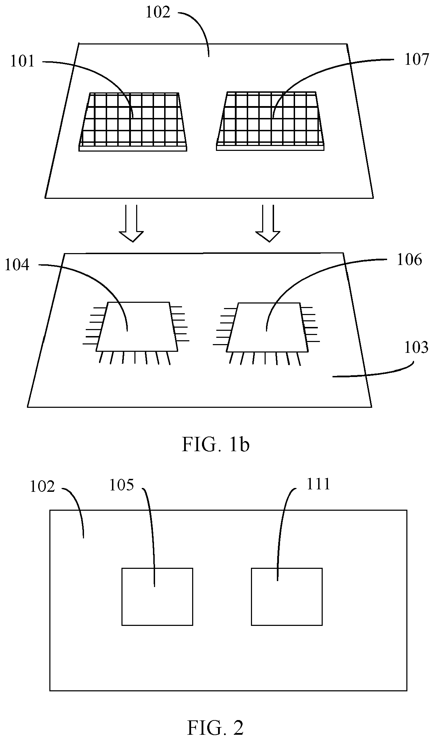

FIG. 1b is an exploded schematic diagram of a structure of a heat dissipation component according to an embodiment of this application. As shown in FIG. 1b, the heat dissipation component provided in this embodiment of this application includes a first heat conduction component 101 and a first fixed plate 102.

In this embodiment of this application, the first fixed plate 102 is fixedly connected to a PCB board 103, where a side of the PCB board 103 is provided with a first heat generating device 104, and the first fixed plate 102 is located on a side, of the first heat generating device 104, facing away from the PCB board 103.

The first fixed plate 102 may be a plate-shaped metal plate made of a material such as aluminum or aluminum alloy, and the first fixed plate 102 and the PCB board 103 may be fixed at an angle parallel or approximately parallel. The PCB board 103 may be a mainboard or a PCB board 103 having another function, provided with one or more heat generating devices. The heat generating device may be a device such as an SOC chip, a local area network switch LAN SW, or a microcontroller unit (microcontroller unit, MCU). The first heat generating device 104 is one of the one or more heat generating devices arranged on the PCB board 103. The PCB board 103 has two faces, and heat generating devices may be arranged on both of the faces. Because the first fixed plate 102 is located on the side, of the first heat generating device 104, facing away from the PCB board 103, the first heat generating device 104 is provided on a face, of the PCB board 103, facing the first fixed plate 102. Optionally, a high-power heat generating device is arranged on one of the two faces of the PCB board 103, and a low-power heat generating device is arranged on the other face, and the first heat generating device 104 may be arranged on the face, of the PCB board 103, on which the high-power heat generating device is arranged, and the first heat generating device 104 may be a high-power heat generating chip.

In this embodiment of this application, the first fixed plate 102 is provided with a first through hole 105, the first heat conduction component 101 passes through the first through hole 105, and the side of the first heat conduction component 101 adheres to the first heat generating device 104. The side of the first heat conduction component 101 may adhere to the first heat generating device 104 through direct contact, or may adhere to the first heat generating device 104 through indirect contact by smearing silicone grease.

FIG. 2 is a schematic diagram of a structure of a fixed plate according to an embodiment of this application. As shown in FIG. 2, the first fixed plate 102 may be provided with the first through hole 105. In this embodiment of this application, the first fixed plate 102 and the PCB board 103 are arranged opposite to each other, and the first fixed plate 102 may be provided with the first through hole 105 in a position opposite to the first heat generating device 104. The first heat conduction component 101 may pass through the first through hole 105 and adheres to the first heat generating device 104.

Specifically, as shown in FIG. 1b, the first through hole 105 may be provided on the first fixed plate 102, and the first heat conduction component 101 is provided in the first through hole 105. During installation, the first fixed plate 102 may be moved towards the PCB board 103, and the first heat conduction component 101 is enabled to adhere to the first heat generating device 104.

In an optional implementation, the first heat conduction component 101 is a water block, and a flow channel and a fin may be included inside the water block. A liquid may be filled in the flow channel, and heat is further taken away by flow of the liquid. The liquid may be water or another refrigeration medium. The first heat conduction component 101 may be alternatively another component with better heat dissipation performance, such as a liquid cooling plate.

In this embodiment of this application, the side of the PCB board 103 may be further provided with a second heat generating device 106, and the heat dissipation component further includes a second heat conduction component 107 and a flexible connector 108. The first heat conduction component 101 and the second heat conduction component 107 are connected through the flexible connector 108. The first fixed plate 102 is further provided with a second through hole 111, the second heat conduction component 107 passes through the second through hole 111, and a side of the second heat conduction component 107 adheres to the second heat generating device 106.

In this embodiment of this application, similar to the first heat generating device 104, the second heat generating device 106 may be further provided on a face, of the PCB board 103, provided with the first heat generating device 104, and the second heat generating device 106 is one of the one or more heat generating devices arranged on the PCB board 103. The PCB board 103 has two faces, and heat generating devices may be arranged on both of the faces. Because the first fixed plate 102 is located on the side, of the second heat generating device 106, facing away from the PCB board 103, the second heat generating device 106 is provided on a face, of the PCB board 103, facing the first fixed plate 102. Similar to the first through hole 105, the first fixed plate 102 and the PCB board 103 are arranged opposite to each other, and the first fixed plate 102 may be provided with the second through hole 111 in a position opposite to the second heat generating device 106. The second heat conduction component 107 may pass through the second through hole 111 and adheres to the second heat generating device 106.

The first heat conduction component 101 and the second heat conduction component 107 are connected through the flexible connector 108 to form a whole, and the flexible pipeline enables the first heat conduction component 101 and the second heat conduction component 107 to move up or move down for a specific distance along a direction perpendicular to a plane of the first fixed plate 102. In some scenarios, the first heat generating device 104 and the second heat generating device 106 are not on the same plane, and in addition, because the first heat conduction component 101 and the second heat conduction component 107 can move up or move down for a specific distance along the direction perpendicular to the plane of the first fixed plate 102, the first heat conduction component 101 and the second heat conduction component 107 can closely adhere to a corresponding heat generating device well. It should be understood that the flexible connector 108 may be a flexible pipe or a combination of a flexible pipe and a rigid pipe (such as a metallic pipe).

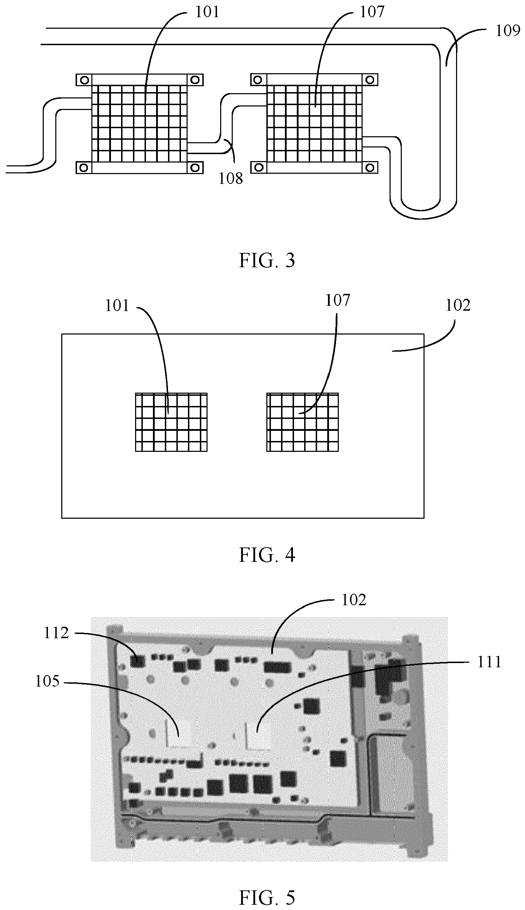

Specifically, refer to FIG. 3. FIG. 3 is a schematic diagram of a structure of a heat dissipation component according to an embodiment of this application. As shown in FIG. 3, the first heat conduction component 101 and the second heat conduction component 107 are connected through the flexible connector 108, the first heat conduction component 101 and the second heat conduction component 107 are water blocks, the flexible connector 108 may be set to hollow, and an empty cavity inside the flexible connector 108 may be used as a liquid flow channel. In addition, the heat dissipation component may include a heat conduction pipe 109. The heat conduction pipe 109 is connected to the first heat conduction component 101, and the heat conduction pipe 109 is connected to the second heat conduction component 107, the heat conduction pipe 109 may be set to hollow, and an empty cavity inside the heat conduction pipe 109 may be used as a liquid flow channel. Optionally, the heat conduction pipe 109 may be a metallic pipe, a plastic pipe with a better heat-conducting property, or the like.

FIG. 4 is a schematic diagram of a structure of a heat dissipation component according to an embodiment of this application. As shown in FIG. 4, along a line of sight towards the PCB board 103, it can be seen that the first heat conduction component 101 is located in the first through hole 105, and the second heat conduction component 107 is located in the second through hole 111.

In a possible implementation, a third heat generating device is further provided on a side of the PCB board 103, a boss 112 is arranged on the side, of the first fixed plate 102, facing the PCB board 103, and a side, of the third heat generating device, facing the first fixed plate 102 adheres to the boss 112.

Optionally, the side, of the first fixed plate 102, facing the PCB board 103 may be alternatively provided with a boss 112 corresponding to a third heat generating device on the PCB board 103. FIG. 5 is a schematic diagram of a structure of a fixed plate according to an embodiment of this application. As shown in FIG. 5, in addition to the first through hole 105 and the second through hole 111, a plurality of bosses 112 may be provided on the side, of the first fixed plate 102, facing the PCB board 103. Each boss 112 corresponds to another heat generating device on the PCB board 103 (a heat generating device other than the first heat generating device 104 and the second heat generating device 106).

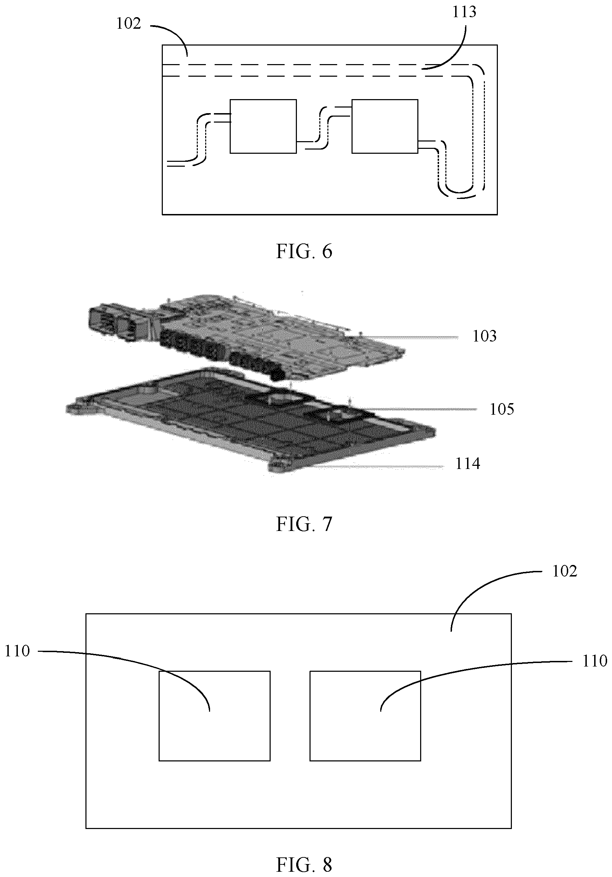

In this embodiment of this application, a groove 113 may be further provided on a side, of the first fixed plate 102, facing the PCB board 103, and the heat conduction pipe 109 adheres to an inner wall of the groove 113. A pipeline of the heat conduction pipe 109 may or may not be in contact with the first fixed plate 102, depending on whether a power of a device on which heat dissipation is required on the PCB board 103 is too high so that the heat dissipation cannot be resolved through natural heat dissipation, and if the power of the device on which the heat dissipation is required on the PCB board 103 is very high, the heat conduction pipe 109 may adhere to the inner wall of the groove 113 on the first fixed plate 102, so that heat generated by the device on which the heat dissipation is required on the PCB board 103 is transferred to the fixed plate. An adhering position may be but not limited to being coated with a specific thermal contact material, such as epoxy resin. FIG. 6 is a schematic diagram of a structure of a fixed plate according to an embodiment of this application. As shown in FIG. 6, the groove 113 may be provided on the side, of the first fixed plate 102, facing the PCB board 103.

In this embodiment of this application, the first heat conduction component 101 may be floatingly connected to the PCB board 103, so that a side of the first heat conduction component 101 adheres to the first heat generating device 104.

In an implementation, FIG. 7 is a schematic diagram of a heat dissipation component according to an embodiment of this application. As shown in FIG. 7, the first heat conduction component 101 may be installed to fit the first fixed plate 102, where the first heat conduction component 101 may directly pass through the first through hole 105 of the first fixed plate 102, and fasten and lock a spring screw and a board bracket 115 to the first heat generating device 104 (the board bracket 115 may be but not limited to being arranged on a bottom housing 114), so that the first heat conduction component 101 can be floatingly connected to the PCB board 103, and further, the first heat conduction component 101 may adhere to the first heat generating device 104.

In this embodiment of this application, a heat generating device may be arranged on the face, of the PCB board 103, facing away from the first fixed plate 102, and is in contact with a long boss 112 on the bottom housing 114, and a contact interface may be filled with a thermal pad or thermal grease. The bottom housing 114 may be a pure metal plate, or a whole cavity-type liquid cooling plate, or the same heat dissipation structure as the first fixed plate 102 and the heat conduction component. This is not limited herein.

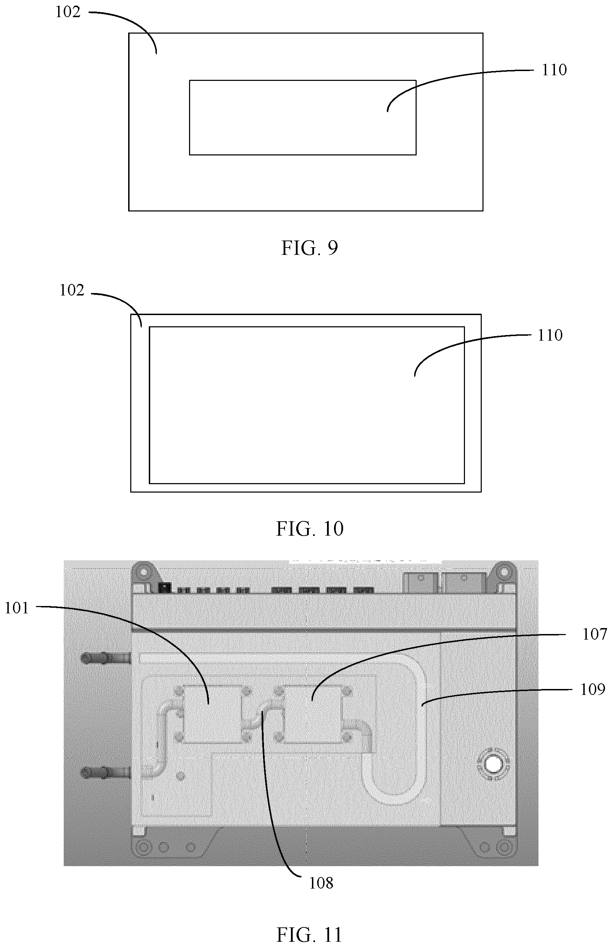

In this embodiment of this application, to seal the through hole provided on the first fixed plate 102, the sealing cover 110 can be fastened onto the side, of the first fixed plate 102, facing away from the PCB board 103, to seal the first through hole 105. Specifically, the sealing cover 110 may be provided on the first fixed plate 102. As shown in FIG. 8, the sealing cover 110 may be locked in a local area near a heat conduction component (the first heat conduction component 101 or the second heat conduction component 107); as shown in FIG. 9, the sealing cover 110 may be locked in a local area near heat conduction components (the first heat conduction component 101 and the second heat conduction component 107), or as shown in FIG. 10, the sealing cover 110 may be locked on an outer edge of the entire first fixed plate 102, and all joints are fastened through sealing rings and screws to meet airtight requirements. FIG. 11 is a schematic diagram of an installed vehicle-mounted computing apparatus.

In this embodiment of this application, the first heat generating device 104 adheres to the first heat conduction component 101, and the first heat conduction component 101 may take away heat from the first heat generating device 104. From a perspective of a size of a heat conduction component, because the first heat conduction component 101 passes through the through hole of the first fixed part, the size of the first heat conduction component 101 may be adapted to a size of the through hole. Compared with a liquid cooling plate in a conventional technology, a dimension and a weight of the first heat conduction component 101 in this embodiment are smaller. In addition, in terms of thickness, because the first heat conduction component 101 passes through the through hole of the first fixed part, a thickness of the heat dissipation component in this embodiment is less than that used when a fixed plate and a liquid cooling plate are separately arranged.

In addition, it should be noted that the described apparatus embodiments are merely examples. The units described as separate parts may or may not be physically separate, and parts displayed as units may or may not be physical units, may be located in one position, or may be distributed on a plurality of network units. Some or all the modules may be selected based on an actual requirement to achieve the objectives of the solutions of embodiments. In addition, in the accompanying drawings of the apparatus embodiments provided in this application, connection relationships between modules indicate that the modules have communication connections with each other, which may be specifically implemented as one or more communication buses or signal cables.

Based on the descriptions of the foregoing implementations, a person skilled in the art may clearly understand that this application may be implemented by software in addition to necessary universal hardware, or by dedicated hardware, including a dedicated integrated circuit, a dedicated CPU, a dedicated memory, a dedicated component, and the like. Usually, any functions that can be performed by a computer program can be easily implemented by using corresponding hardware. Moreover, a specific hardware structure used to achieve a same function may be of various forms, for example, an analog circuit, a digital circuit, or a dedicated circuit. However, as for this application, software program implementation is a better implementation in most cases. Based on such an understanding, the technical solutions of this application essentially or the part contributing to the conventional technology may be implemented in a form of a software product. The software product is stored in a readable storage medium, such as a floppy disk, a USB flash drive, a removable hard disk, a ROM, a RAM, a magnetic disk, or an optical disc of a computer, and includes several instructions for instructing a computer device (which may be a personal computer, a training device, a network device, or the like) to perform the methods described in embodiments of this application.

All or some of the foregoing embodiments may be implemented by using software, hardware, firmware, or any combination thereof. When software is used for implementation, all or some of embodiments may be implemented in a form of a computer program product.

The computer program product includes one or more computer instructions. When the computer program instructions are loaded and executed on a computer, the procedures or functions according to embodiments of this application are all or partially generated. The computer may be a general-purpose computer, a dedicated computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, training device, or data center to another website, computer, training device, or data center in a wired (for example, a coaxial cable, an optical fiber, or a digital subscriber line (DSL)) or wireless (for example, infrared, radio, or microwave) manner. The computer-readable storage medium may be any usable medium accessible by the computer, or a data storage device, such as a training device or a data center, integrating one or more usable media. The usable medium may be a magnetic medium (for example, a floppy disk, a hard disk, or a magnetic tape), an optical medium (for example, a DVD), a semiconductor medium (for example, a solid-state drive (Solid-State Drive, SSD)), or the like.

## Claims

1. A heat dissipation component, comprising: a first heat conduction component (101) and a first fixed plate (102), wherein
the first fixed plate (102) is fixedly connected to a PCB board (103), a side of the PCB board (103) is provided with a first heat generating device (104), and the first fixed plate (102) is located on a side, of the first heat generating device (104), facing away from the PCB board (103); and
the first fixed plate (102) is provided with a first through hole (105), the first heat conduction component (101) passes through the first through hole (105), and a side of the first heat conduction component (101) adheres to the first heat generating device (104).

2. The heat dissipation component according to claim 1, wherein the side of the PCB board (103) is further provided with a second heat generating device (106), and the heat dissipation component further comprises: a second heat conduction component (107) and a flexible connector (108);
the first heat conduction component (101) and the second heat conduction component (107) are connected through the flexible connector (108); and
the first fixed plate (102) is further provided with a second through hole (111), the second heat conduction component (107) passes through the second through hole (111), and a side of the second heat conduction component (107) adheres to the second heat generating device (106).

3. The heat dissipation component according to claim 1 or 2, wherein the first heat conduction component (101) is a water block.

4. The heat dissipation component according to any one of claims 1 to 3, further comprising: a heat conduction pipe (109), wherein
the heat conduction pipe (109) is connected to the first heat conduction component (101), a groove 113 is provided on a side, of the first fixed plate (102), facing the PCB board (103), and the heat conduction pipe (109) adheres to an inner wall of the groove 113.

5. The heat dissipation component according to claim 4, wherein the heat conduction pipe (109) is a metallic pipe.

6. The heat dissipation component according to any one of claims 1 to 5, wherein a third heat generating device is further provided on a side of the PCB board (103), a boss 112 is arranged on the side, of the first fixed plate (102), facing the PCB board (103), and a side, of the third heat generating device, facing the first fixed plate (102) adheres to the boss 112.

7. The heat dissipation component according to any one of claims 1 to 6, wherein the first heat conduction component (101) is floatingly connected to the PCB board (103), so that a side of the first heat conduction component (101) adheres to the first heat generating device (104).

8. The heat dissipation component according to any one of claims 1 to 7, further comprising: a sealing cover (110), wherein
the sealing cover (110) is fastened onto a side, of the first fixed plate (102), facing away from the PCB board (103), to seal the first through hole (105).

9. A vehicle, comprising a vehicle body, and the heat dissipation component according to any one of claims 1 to 8 provided in the vehicle body.
